# FASCICULE DE BREVET EUROPEEN

(11) **EP 3 504 358 B1**
(45) Date de publication et mention de la délivrance du brevet: **27.09.2023**
(21) Numéro de dépôt: 17768836.3
(22) Date de dépôt: 25.08.2017
(51) Int. Cl.: C23C 28/00, C23C 14/08, C23C 14/30, C23C 14/58, C23C 4/073, C23C 4/134

(54) **PROCÉDÉ DE RÉALISATION D'UN SYSTÈME BARRIÈRE THERMIQUE SUR UN SUBSTRAT MÉTALLIQUE D'UNE PIÈCE DE TURBOMACHINE**
VERFAHREN ZUR HERSTELLUNG EINES WÄRMEDÄMMSYSTEMS AUF EINEM METALLISCHEN SUBSTRAT EINES TURBOMASCHINENTEILS
METHOD FOR PRODUCING A THERMAL BARRIER SYSTEM ON A METAL SUBSTRATE OF A TURBO ENGINE PART

(30) Priorité: 25.08.2016 FR 1657941
(43) Date de publication de la demande: 03.07.2019
(73) Titulaire: SAFRAN, 75015 Paris (FR)
(72) Inventeur: BEN SALAH, Nihad, 77550 Moissy-Cramayel (FR); BADREDDINE, Jawad, 77550 Moissy-Cramayel (FR); JOULIA, Aurélien, 77550 Moissy-Cramayel (FR)
(74) Mandataire: Gevers & Orès
(86) Numéro de dépôt international: PCT/FR2017/052284
(87) Numéro de publication internationale: WO 2018/037196

(56) Documents cités:
- EP-A2- 1 531 232
- WO-A1-2009/127725
- CN-A- 105 369 202
- DATABASE COMPENDEX [Online] ENGINEERING INFORMATION, INC., NEW YORK, NY, US; avril 2002 (2002-04), PFEIFFER W ET AL: "Shot peening of ceramics: Damage or benefit?", XP002774977, Database accession no. E2002196941268 & CFI CERAMIC FORUM INTERNATIONAL APRIL 2002 BAUVERLAG GMBH DE, vol. 79, no. 4, avril 2002 (2002-04), pages D18+E25-E28, cité dans la demande
- WULF PFEIFFER ET AL: "Strengthening of Ceramics by Shot Peening", MATERIALS SCIENCE FORUM, vol. 404-407, 1 janvier 2002 (2002-01-01), pages 101-108, XP055418341, DOI: 10.4028/www.scientific.net/MSF.404-407.101
- KOJI TAKAHASHI ET AL: "Increase in Strength of Partially Stabilized Zirconia After Shot Peening", JOURNAL OF MATERIALS ENGINEERING AND PERFORMANCE., vol. 24, no. 9, 1 septembre 2015 (2015-09-01), pages 3573-3578, XP055418361, US ISSN: 1059-9495, DOI: 10.1007/s11665-015-1623-x
- Ki-Woo Nam: "Ceramic Processing Research Characteristics of crack growth of zirconia composites by shot peening", Journal of Ceramic Processing Research, 1 juin 2016 (2016-06-01), pages 543-549, XP055418374, Extrait de l'Internet: URL:http://jcpr.kbs-lab.co.kr/file/JCPR_vo l.17_2016/JCPR17-6/04.2015-121_543-549.pdf [extrait le 2016-10-24]
- HENRYK TOMASZEWSKI ET AL: "Shot Peening - A New Method for Improving Mechanical Properties of Structural Ceramics", KEY ENGINEERING MATERIALS, vol. 317-318, 1 janvier 2006 (2006-01-01), pages 277-280, XP055418413, DOI: 10.4028/www.scientific.net/KEM.317-318.277
- D KIRK: "Metrology of Almen Arc Height Measurement", THE SHOT PEENER, vol. 22, no. 2, 14 mai 2008 (2008-05-14), pages 24-34, XP055062037, ISSN: 1069-2010
- Rubing Zhang ET AL: "Strengthening of ultra high-temperature ceramics by shot peening and multiple crack healing", MATERIALS LETTERS, vol. 160, 1 December 2015 (2015-12-01), pages 132-134, XP055418379, AMSTERDAM, NL ISSN: 0167-577X, DOI: 10.1016/j.matlet.2015.07.064
- V Harok ET AL: "Elastic and inelastic effects in compression in plasma-sprayed ceramic coatings", ournal of Thermal Spray Technology, vol. 10, no. 1, 1 March 2001 (2001-03-01), pages 126-132, XP055366824, DOI: 10.1361/105996301770349592
- DATABASE COMPENDEX [Online] ENGINEERING INFORMATION, INC., NEW YORK, NY, US; April 2002 (2002-04), PFEIFFER W ET AL: "Shot peening of ceramics: Damage or benefit?", Database accession no. E2002196941268 & PFEIFFER W ET AL: "Shot peening of ceramics: Damage or benefit?", CFI CERAMIC FORUM INTERNATIONAL APRIL 2002 BAUVERLAG GMBH DE, vol. 79, no. 4, April 2002 (2002-04), pages D18+E25-E28,
- BENJAMIN BERNARD; LUC BIANCHI; ANDRÉ MALIÉ; AURÉLIEN JOULIA; BENJAMIN RÉMY: "Columnar suspension plasma sprayed coating microstructural controlfor thermal barrier coating application", JOURNAL OF THE EUROPEAN CERAMIC SOCIETY, vol. 36, 28 November 2015 (2015-11-28), pages 1081-1089, XP029373540,

## Description

### DOMAINE TECHNIQUE

Le domaine de la présente invention est celui des turbomachines, et plus particulièrement celui des pièces de ces turbomachines qui sont soumises à de fortes températures, telles que les aubes de turbine haute pression.

### ETAT DE L'ART

Une turbomachine, telle qu'utilisée pour la propulsion dans le domaine aéronautique, comprend une entrée d'air atmosphérique qui communique avec un ou plusieurs compresseurs, dont généralement une soufflante, entraînés en rotation autour d'un même axe. Le flux primaire de cet air, après avoir été comprimé, alimente une chambre de combustion disposée annulairement autour de cet axe et est mélangé à un carburant pour fournir des gaz chauds, en aval, à une ou plusieurs turbines à travers lesquelles ceux-ci sont détendus, les rotors de turbine entraînant les rotors des compresseurs. Les moteurs fonctionnent à une température des gaz chauds en entrée de turbine que l'on cherche aussi élevée que possible, car cette température conditionne les performances de la turbomachine. Dans ce but, les matériaux des parties chaudes sont sélectionnés pour résister à ces conditions de fonctionnement et les parois des pièces balayées par les gaz chauds, telles que les distributeurs ou les ailettes mobiles de turbine, sont pourvues de moyens de refroidissement. Par ailleurs, en raison de la constitution métallique en superalliage à base de nickel ou de cobalt de ces aubes, il est également nécessaire de les prémunir contre l'érosion et la corrosion qui sont engendrées par les constituants des gaz chauds à ces températures.

Parmi les protections imaginées pour permettre à ces pièces de résister à ces conditions extrêmes, figure le dépôt de plusieurs matériaux formant un « système barrière thermique », sur leur face externe. Un système barrière thermique se compose généralement d'une couche céramique d'environ une centaine de microns, qui est déposée à la surface de la couche métallique. Une sous-couche en aluminium, appelée couche de liaison, de quelques dizaines de microns, placée entre la céramique et le substrat métallique, complète la barrière thermique en assurant la liaison entre ces deux composants ainsi que la protection du métal sous-jacent contre l'oxydation. Cette sous-couche en aluminium, qui est généralement déposée par un procédé d'aluminisation en phase vapeur, se fixe au substrat par inter-diffusion métallique et forme une couche protectrice d'oxyde en surface. Un exemple de la mise en oeuvre de cette technique est décrit dans le document FR 2928664.

Quant à la barrière thermique proprement dite, en céramique, elle peut être réalisée de plusieurs façons, selon l'utilisation qui en sera faite. On distingue grossièrement deux types de structures pour les barrières thermiques : des barrières colonnaires dont la structure est celle de colonnes juxtaposées les unes à côté des autres et qui s'étendent perpendiculairement à la surface du substrat, et des barrières lamellaires ou isotropes qui s'étendent en couches uniformes sur la surface du substrat.

Les barrières colonnaires sont généralement réalisées par un procédé dit EBPVD (pour Electron Beam Physical Vapor Deposition en langue anglaise ou dépôt physique en phase vapeur par faisceau d'électrons) dans lequel une anode cible est bombardée, sous vide poussé, par un faisceau d'électrons émis par un filament de tungstène chargé. Le faisceau d'électrons fait passer les molécules de la cible en phase gazeuse. Ces molécules précipitent alors sous une forme solide, recouvrant la pièce à protéger d'une couche mince du matériau de l'anode. Ces barrières thermiques se caractérisent par une bonne résistance thermique mais aussi par une conductivité thermique relativement élevée.

Le système barrière thermique vieillit, du fait des phénomènes couplés d'oxydation cyclique, d'érosion, d'exposition à un environnement riche en un ensemble de particules d'oxydes communément appelés CMAS (pour oxydes de calcium, magnésium, aluminium et silicium). Le vieillissement entraîne une dégradation rapide du système.

Des mécanismes multiples se produisent, et en particulier :
- une augmentation de la rugosité de la couche de liaison, du fait de l'oxydation croissante, entraînant le décollement de la barrière thermique,
- l'infiltration des oxydes CMAS dans les espaces intercolonnaires de la céramique, causant sa fragilisation,
- une faible résistance aux chocs avec des corps étrangers, du fait de la faible ténacité des matériaux céramiques.

Le document V HAROK ET AL. : « Elastic and inelastic effects in compression in plasma-sprayed ceramic coatings », JOURNAL OF THERMAL SPRAY TECHNOLOGY, vol. 10, no. 1, 1 mars 2001, pages 126-132, est une étude de la compression d'un revêtement de zircon obtenu par projection thermique à la torche à plasma. Ce document ne décrit pas de compression d'une couche de céramique colonnaire dans un système barrière thermique.

Le document EP 1 531 232 A2 décrit un procédé de réparation d'un système barrière thermique endommagé. Ce document mentionne la possibilité de l'enlèvement de la barrière thermique par un procédé abrasif à l'aide de billes en verre, mais ne divulgue pas de grenaillage de compression d'une couche de céramique colonnaire dans un système barrière thermique.

Le document WO 2009/127725 A1 décrit un procédé de grenaillage par ultrasons d'une surface métallique comprenant une surface d'accès difficile. Ce document ne décrit pas non plus de compression d'une couche de céramique colonnaire dans un système barrière thermique.

La présente invention vise à remédier à ces inconvénients, en proposant un procédé de réalisation d'un système barrière thermique permettant de lutter contre le vieillissement du système.

### EXPOSE DE L'INVENTION

L'invention a ainsi pour objet un procédé de réalisation d'un système barrière thermique sur un substrat métallique d'une pièce de turbomachine, telle qu'une aube de turbine haute pression, le système barrière thermique comprenant au moins une couche de céramique colonnaire.

Conformément à l'invention, le procédé comprend une étape de compression d'au moins une de ladite au moins une couche de céramique colonnaire. La compression peut être partielle ou totale. La couche de céramique comprimée comprend ainsi au moins une partie comprimée.

Le document T. Frey and W. Pfeiffer, « Shot peening of Ceramics : Damage or Benefit ? », International Conférence on Shot Peening, 2002, pp. 1-10, indique que l'introduction de contraintes de compression par grenaillage dans des céramiques est possible sans les endommager.

KOJI TAKAHASHI ET AL,JOURNAL OF MATERIALS ENGINEERING AND PERFORMANCE., vol. 24, no. 9, 1 septembre 2015 (2015-09-01), pages 3573-3578, décrit l'augmentation de la résistance mécanique de la zircone partiellement stabilisée après grenaillage de précontrainte.

L'étape de compression est utilisée dans l'invention dans une céramique spécifique, et dans un but bien spécifique, non envisagés par l'état de la technique : resserrer les espaces entre les colonnes d'une ou plusieurs couches de céramique colonnaire , ce qui a pour effet de limiter les infiltrations des oxydes CMAS, d'augmenter la durée de vie du système barrière thermique, et d'améliorer les propriétés mécaniques du système barrière thermique.

La compression est apte à réduire les espaces entre les colonnes de la ou des couches de céramique colonnaires comprimées. La compression induit en effet une déformation à la surface de la ou des couches comprimées, ladite déformation entraînant une réduction des espaces entre les colonnes.

La compression peut être par exemple un grenaillage, un microbillage ou encore une compression par choc laser.

La compression d'au moins une de ladite couche de céramique colonnaire peut être un grenaillage et l'intensité d'Almen dudit grenaillage est avantageusement comprise entre F10A et F42A.

Il s'agit d'un repère technologique mis au point par Almen (Général Motors, USA) et universellement adopté (Norme AFNOR NFL 06-832). On utilise une éprouvette en acier au carbone de type XC65 trempée et revenue, bridée sur un support et exposée à un jet de grenaille, au voisinage immédiat des pièces à grenailler. Lorsque l'éprouvette est libérée de ses brides, elle se déforme car la face grenaillée est allongée. On observe alors une flèche caractéristique appelée flèche d'Almen. Les normes définissent trois types d'éprouvettes N, A, C. A titre d'exemple, un grenaillage d'intensité Almen F15A signifie F: Norme Française, 15: flèche de 0.15 mm, A: éprouvette de type A.

Pour obtenir cette intensité, on peut utiliser les paramètres suivants, seuls ou de préférence en combinaison :
- micro-billes de forme sphérique (le grenaillage est une technique consistant à projeter, à l'aide d'une grenailleuse, des micro-billes sur la surface d'un objet pour en modifier la structure superficielle et introduire des contraintes de compression),
- matériau des micro-billes : WC, ZrO₂, SiO₂, Al₂O₃, acier,
- la taille des billes est comprise entre 300 µm et 1 mm pour un grenaillage à buse, entre 0.8 et 3 mm pour un grenaillage à ultrasons, et entre 1 et 6 mm pour un vibro-grrenaillage,
- les angles d'incidence pour le grenaillage à buse sont compris entre 60 et 90°.

Ledit substrat est typiquement un substrat en superalliage à base de nickel ou de cobalt.

Ladite au moins une couche de céramique colonnaire peut être une couche de zircone yttriée.

Ladite au moins une couche de céramique colonnaire peut être obtenue par dépôt physique en phase vapeur.

Le dépôt en physique en phase vapeur peut être un dépôt physique en phase vapeur par faisceau d'électrons (EBPVD).

Le système barrière thermique peut comprendre une ou plusieurs couches de céramique colonnaires, et le procédé peut comprendre la compression d'une ou de l'ensemble des couches de céramique colonnaires.

Le procédé peut en particulier comprendre la compression de la couche supérieure de céramique ou la compression de la couche de céramique située directement sous ladite couche supérieure.

Le système barrière thermique peut comprendre en outre une couche de liaison disposée entre ledit substrat métallique et ladite au moins une couche de céramique colonnaire.

Ladite couche de liaison peut être une couche d'un matériau, notamment alumino-formeur, comprenant en surface une couche d'alumine.

Le procédé peut comprendre une étape de compression de ladite couche de liaison. Lorsque la compression de ladite couche de liaison est un grenaillage, l'intensité d'Almen du grenaillage est avantageusement comprise entre F9N et F30A.

Le procédé peut comprendre successivement :
- la formation d'une couche de liaison sur le substrat métallique, la couche de liaison pouvant être comprimée,
- la formation, sur la couche de liaison, d'une ou plusieurs couches de céramique, au moins une de la ou desdites couches de céramique pouvant être comprimée.

L'invention a également pour objet une pièce de turbomachine, telle qu'une aube de turbine haute pression. Ladite pièce de turbomachine comprend un système barrière thermique réalisé par un procédé décrit ci-dessus. L'aube peut être par exemple une aube fixe ou une aube mobile de turbine haute pression.

### DESCRIPTION DES FIGURES

L'invention sera mieux comprise et d'autres détails, caractéristiques et avantages de l'invention apparaîtront à la lecture de la description suivante faite à titre d'exemple non limitatif et en référence aux dessins annexés dans lesquels :
- la figure 1 est une vue schématique en coupe d'un système barrière thermique d'une aube de turbomachine de l'état de la technique,
- les figures 2 et 3 sont des vues schématiques en coupe d'un système barrière thermique réalisé selon un procédé selon l'invention, conformément à deux variantes d'un premier mode de réalisation ;
- la figure 4 est une vue schématique en coupe d'un système barrière thermique réalisé selon un procédé selon l'invention, conformément à un deuxième mode de réalisation ;
- les figures 5 et 6 sont des vues schématiques en coupe d'un système barrière thermique réalisé selon un procédé selon l'invention, conformément à deux variantes d'un troisième mode de réalisation ;
- la figure 7 est une vue schématique en coupe d'un système barrière thermique réalisé selon un procédé selon l'invention, conformément à un quatrième mode de réalisation;
- la figure 8 est une vue schématique en coupe d'un système barrière thermique réalisé selon un procédé selon l'invention, conformément à un cinquième mode de réalisation.

### DESCRIPTION DETAILLEE

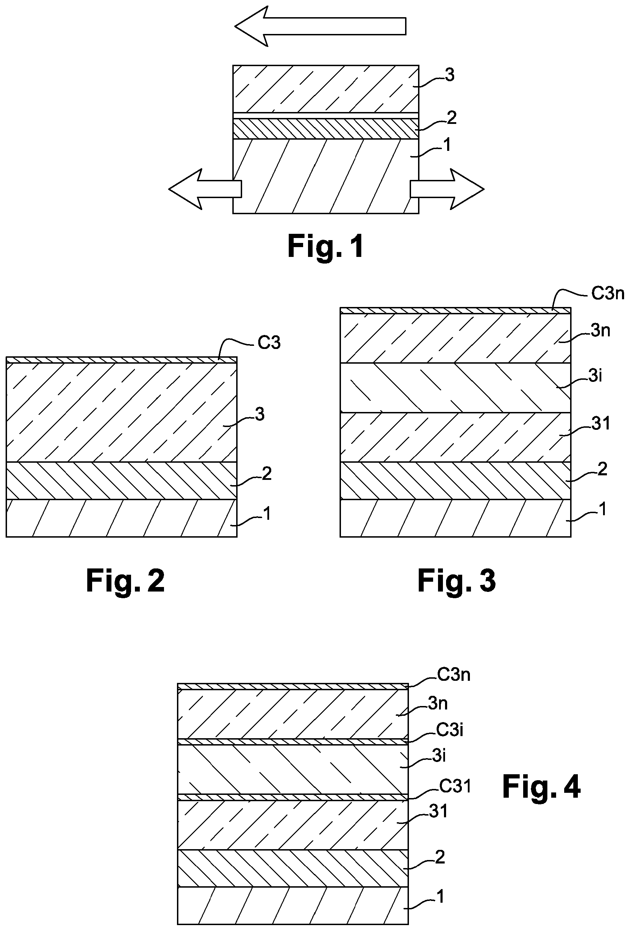

En se référant à la figure 1, on voit en coupe la composition d'un système barrière thermique déposé sur la surface d'une aube de turbine, celle-ci étant baignée par un flux de gaz chaud représenté par une flèche dirigée vers la gauche de la figure. Le métal constituant l'aube, typiquement un super alliage à base nickel ou cobalt, forme un substrat 1 sur lequel est déposée une sous-couche en aluminium 2, dite couche de liaison, prise en sandwich entre le substrat 1 et une couche céramique 3. La fonction de la couche de liaison 2 est de retenir la couche céramique 3 et d'offrir une certaine élasticité à l'ensemble pour lui permettre d'absorber la différence de dilatation, représentée par deux flèches de sens opposé, existant entre le substrat 1 à forte dilatation et la céramique 3 à faible dilatation.

La couche de liaison 2 peut être de formule MCrAlY, dans laquelle M désigne Fe, Ni, Co et leurs mélanges. Elle peut être obtenue par projection plasma conventionnelle, par exemple de type APS (Air Plasma Spraying en langue anglaise). La couche de liaison 2 de type MCrAlY peut être remplacée par une aluminure de nickel ou modifiée par le platine, ou par une couche de type gamma/gamma'-MCrAIY.

La céramique 3 représentée ici est à structure colonnaire, ce qui autorise des déplacements latéraux, du fait de l'apparition de fissures entre les colonnes, et ce qui lui confère une bonne durée de vie. L'aluminium est alors mis en contact avec de l'oxygène véhiculé par les gaz qui circulent dans la veine de la turbomachine, ce qui se traduit par une conductivité thermique moyenne de la barrière et un endommagement progressif de celle-ci.

Le revêtement céramique peut être constitué d'un empilement d'une ou plusieurs couches, réalisées par exemple par un dépôt physique en phase vapeur sous faisceau d'électrons (EBPVD). La première couche de céramique est préférentiellement à base de zircone yttriée partiellement stabilisée YSZ (pour Yttria-Stabilized Zirconia en langue anglaise). Pour les autres couches de céramique, différents types de couches peuvent être envisagés :
- un mono oxyde, comme par exemple Al₂O₃ ou Y₂O₃,
- une zircone dopée par un ou plusieurs oxydes de terres rares,
- un zirconate de terre rare, comme par exemple Gd₂Zr₂O₇, Sm₂Zr₂O₇ ou Yb₄Zr₃O₁₂,
- une pérovskite, comme par exemple Ba(Mg_{1/3}Ta_{2/3})O₃, La(Al_{1/4}Mg_{1/2}Ta_{1/4})O₃,
- un hexaaluminate, par exemple de formule générale REMA1₁₁O₁₉, dans laquelle RE désigne un élément allant de La à Gd dans le tableau périodique, et M désigne un élément choisi parmi Mg, Mn à Zn, Cr et Sm,
- les orthophosphates de lanthanides.

Le système barrière thermique a pour fonction de prolonger la durée de vie de l'aube et d'augmenter la température des gaz, et donc le rendement du moteur. En service, la structure et la composition des différents constituants du système évoluent sous l'action du frittage de la couche céramique, de l'oxydation de la couche de liaison et des phénomènes d'interdiffusion avec le substrat, avec pour conséquences une modification des propriétés des différentes couches et une altération de la résistance de la zone interfaciale. Ces modifications, associées aux sollicitations thermo-mécaniques extérieures, sont à l'origine de la rugosité de la couche de liaison conduisant à des délaminages à l'interface couche de liaison/céramique, et, in fine, à l'écaillage du système barrière thermique. Ces processus de dégradation peuvent être accélérés par les interactions avec l'environnement extérieur.

Pour y remédier, et conformément à l'invention, on procède à la compression d'au moins une couche de céramique colonnaire.

Dans un premier mode de réalisation, on procède à la compression de la couche supérieure de céramique colonnaire. Tel qu'illustré à la figure 2, le revêtement céramique comprend une unique couche 3 de céramique, par exemple de type YSZ. La couche 3 de céramique subit une opération de mise en compression C3, de manière à resserrer les espaces intercolonnaires à la surface, ce qui a pour effet :
- une limitation des infiltrations des oxydes CMAS,
- une augmentation de la durée de vie du système barrière thermique,
- une amélioration des propriétés mécaniques, telle que la dureté superficielle,
- une augmentation de la résistance à l'érosion, et
- une augmentation de la ténacité du système barrière thermique.

La compression de la couche 3 de céramique est symbolisée sur la figure 2 par la référence C3 illustrant une portion de couche comprimée. La couche 3 peut être comprimée de manière partielle ou totale, c'est-à-dire sur tout ou partie de la hauteur de la couche 3.

Dans la variante illustrée à la figure 3, le revêtement céramique comprend une pluralité de n couches de céramique. Une couche inférieure 31 repose sur la couche de liaison 2. En remontant vers la surface du système barrière thermique, on trouve une couche intermédiaire 3i et la couche supérieure 3n. La compression de la couche supérieure 3n de céramique est symbolisée sur la figure 2 par la référence C3n. La couche 3n peut être comprimée de manière partielle ou totale, c'est-à-dire sur tout ou partie de la hauteur de la couche 3n. La mise en compression C3n permet de resserrer les espaces intercolonnaires à la surface du système barrière thermique et procure les mêmes avantages que ceux mentionnés pour la figure 2.

Dans un deuxième mode de réalisation, illustré à la figure 4, chaque couche du revêtement céramique qui comprend n couches est soumise à une compression, partielle ou totale. Ainsi, la première couche 31, par exemple de type YSZ, est soumise à une compression C31, chaque couche intermédiaire 3i est soumise à une compression C3i et la couche supérieure 3n est soumise à une compression C3n.

Le substrat 1 de l'aube de turbine est préalablement revêtu ou non d'une couche de liaison 2 de type MCrAlY, M désignant Fe, Ni, Co et leurs mélanges. La couche de liaison 2 peut être obtenue par projection plasma conventionnelle, par exemple de type APS (Air Plasma Spraying en langue anglaise). La couche de liaison 2 de type MCrAlY peut être remplacée par une aluminure de nickel ou modifiée par le platine, ou par une couche de type gamma/gamma'-MCrAIY.

Le revêtement céramique est constitué d'un empilement de n couches 31, ..., 3i, ..., 3n, réalisées par le procédé de dépôt physique en phase vapeur sous faisceau d'électrons (EBPVD). La première couche 3i est préférentiellement à base de zircone yttriée partiellement stabilisée.

Après la réalisation de chaque couche de céramique par EBPVD, une opération de mise en compression est effectuée permettant d'obtenir un état de surface moins rugueux, ayant pour effets l'amélioration de la regermination de colonnes plus petites et d'espaces intercolonnaires de plus en plus resserrés au fur et à mesure de la formation des couches supérieures. Ces compressions entraînent :
- une limitation des infiltrations des oxydes CMAS ;
- une augmentation de la durée de vie du système barrière thermique, et
- une augmentation de la ténacité du système barrière thermique.

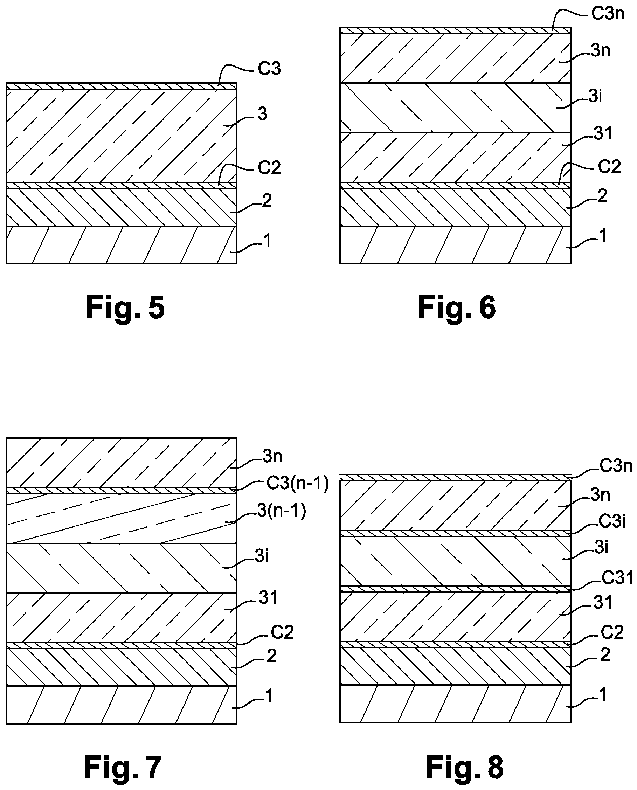

Dans un troisième mode de réalisation, illustré aux figures 5 et 6, la couche de liaison du système barrière thermique des deux variantes du premier mode de réalisation est également soumise à une compression, partielle ou totale. Ainsi, le système barrière thermique voit à la fois sa couche de liaison et sa couche supérieure de céramique mises en compression. La figure 5 illustre le système barrière thermique avec une seule couche 3 de céramique, tandis que la figure 6 illustre le système barrière thermique avec n couches 31, ..., 3i, ..., 3n de céramique.

Le substrat 1 de l'aube de turbine est préalablement revêtu d'une couche de liaison 2 de type MCrAlY, M désignant Fe, Ni, Co et leurs mélanges. La couche de liaison 2 peut être obtenue par projection plasma conventionnelle, par exemple de type APS (Air Plasma Spraying en langue anglaise). La couche de liaison 2 de type MCrAlY peut être remplacée par une aluminure de nickel ou modifiée par le platine, ou par une couche de type gamma/gamma'-MCrAIY.

La mise en compression de la couche de liaison 2 permet :
- une densification partielle ou totale de la couche de liaison 2 et un contrôle de sa rugosité, avec comme effet recherché la réduction de la cinétique de déformation de cette couche au cours du cycle thermique ;
- la génération de contraintes résiduelles ayant pour effet une augmentation de la dureté de la couche 2.

Dans un quatrième mode de réalisation, illustré à la figure 7, la couche de liaison 2 et l'avant-dernière couche supérieure 3(n-1) de céramique sont soumises à une compression C2 et C3(n-1) respectivement, partielle ou totale.

Enfin, dans un cinquième mode de réalisation, la couche de liaison 2 et l'ensemble des couches 31, ..., 3i, ..., 3n de céramique sont soumises à une compression (figure 8).

## Revendications

1. Procédé de réalisation d'un système barrière thermique sur un substrat métallique (1) d'une pièce de turbomachine, telle qu'une aube de turbine haute pression, le système barrière thermique comprenant au moins une couche de céramique colonnaire (3 ; 31,..., 3i,..., 3n), **caractérisé en ce que** le procédé comprend une étape de compression d'au moins une de ladite au moins une couche de céramique colonnaire (3 ; 31,..., 3i,..., 3n) ; et **en ce que** la compression est apte à réduire les espaces entre les colonnes de la ou des couches de céramique colonnaires (3 ; 31,..., 3i,..., 3n) comprimées.

2. Procédé selon la revendication 1, **caractérisé en ce que** la compression est un grenaillage, un microbillage ou une compression par choc laser.

3. Procédé selon la revendication 2, **caractérisé en ce que** la compression d'au moins une de ladite couche de céramique colonnaire (3 ; 31,..., 3i,..., 3n) est un grenaillage et **en ce que** l'intensité d'Almen dudit grenaillage est comprise entre F10A et F42A.

4. Procédé selon l'une des revendications 1 à 3, **caractérisé en ce que** ledit substrat (1) est un substrat en superalliage à base de nickel ou de cobalt.

5. Procédé selon l'une des revendications 1 à 4, **caractérisé en ce que** ladite au moins une couche de céramique colonnaire (3 ; 31, ..., 3i, ..., 3n) est une couche de zircone yttriée.

6. Procédé selon l'une des revendications 1 à 5, **caractérisé en ce que** ladite au moins une couche de céramique colonnaire (3 ; 31,..., 3i ..., 3n) est obtenue par dépôt physique en phase vapeur.

7. Procédé selon la revendication 6, **caractérisé en ce que** le dépôt en phase vapeur est un dépôt physique en phase vapeur par faisceau d'électrons (EBPVD).

8. Procédé selon l'une des revendications 1 à 7, **caractérisé en ce que** le système barrière thermique comprend plusieurs couches de céramique colonnaires (31,..., 3i,..., 3n), et **en ce que** le procédé comprend la compression d'une ou de l'ensemble des couches de céramique colonnaires (31,..., 3i,..., 3n).

9. Procédé selon la revendication 8, **caractérisé en ce que** le procédé comprend la compression de la couche supérieure de céramique (3n) ou la compression de la couche de céramique (3(n-1)) située directement sous ladite couche supérieure (3n).

10. Procédé selon l'une des revendications 1 à 9, **caractérisé en ce que** le système barrière thermique comprend en outre une couche de liaison (2) disposée entre ledit substrat métallique (1) et ladite au moins une couche de céramique colonnaire (3 ; 31,..., 3i,..., 3n).

11. Procédé selon la revendication 10, **caractérisé en ce que** ladite couche de liaison (2) est une couche d'un matériau alumino-formeur comprenant en surface une couche d'alumine.

12. Procédé selon la revendication 10 ou 11, **caractérisé en ce que** le procédé comprend une étape de compression de ladite couche de liaison (2).

13. Procédé selon la revendication 12, **caractérisé en ce que** la compression de ladite couche de liaison (2) est un grenaillage et **en ce que** l'intensité d'Almen dudit grenaillage est comprise entre F9N et F30A.

## Patentansprüche

1. Verfahren zur Herstellung eines Wärmedämmsystems auf einem metallischen Substrat (1) eines Turbomaschinenteils, wie einer Hochdruck-Turbinenschaufel, wobei das Wärmedämmsystem mindestens eine säulenförmige Keramikschicht (3; 31,..., 3i,..., 3n) umfasst, **dadurch gekennzeichnet, dass** das Verfahren einen Schritt der Komprimierung mindestens einer der mindestens einen säulenförmigen Keramikschicht (3; 31,..., 3i,..., 3n) umfasst; und dadurch, dass die Komprimierung geeignet ist, die Räume zwischen den Säulen der komprimierten säulenförmigen Keramikschicht oder -schichten (3; 31,..., 3i,..., 3n) zu verringern.

2. Verfahren nach Anspruch 1, **dadurch gekennzeichnet, dass** es sich bei der Komprimierung um ein Kugelstrahlen, ein Mikrokugelstrahlen oder eine Komprimierung durch Laserschock handelt.

3. Verfahren nach Anspruch 2, **dadurch gekennzeichnet, dass** es sich bei der Komprimierung mindestens einer der säulenförmigen Keramikschicht (3; 31,..., 3i,..., 3n) um ein Kugelstrahlen handelt und dadurch, dass die Almenintensität des Kugelstrahlens zwischen F10A und F42A beträgt.

4. Verfahren nach einem der Ansprüche 1 bis 3, **dadurch gekennzeichnet, dass** es sich bei dem Substrat (1) um ein Substrat aus einer Superlegierung auf Nickel- oder Cobaltbasis handelt.

5. Verfahren nach einem der Ansprüche 1 bis 4, **dadurch gekennzeichnet, dass** es sich bei der mindestens einen säulenförmigen Keramikschicht (3; 31,..., 3i,..., 3n) um eine Schicht aus yttriertem Zirkon handelt.

6. Verfahren nach einem der Ansprüche 1 bis 5, **dadurch gekennzeichnet, dass** die mindestens eine säulenförmige Keramikschicht (3; 31,..., 3i,..., 3n) durch physikalische Gasphasenabscheidung erhalten wird.

7. Verfahren nach Anspruch 6, **dadurch gekennzeichnet, dass** es sich bei der Gasphasenabscheidung um physikalische Gasphasenabscheidung durch Elektronenstrahlverdampfung (EBPVD) handelt.

8. Verfahren nach einem der Ansprüche 1 bis 7, **dadurch gekennzeichnet, dass** das Wärmedämmsystem mehrere säulenförmige Keramikschichten (31,..., 3i,..., 3n) umfasst und dadurch, dass das Verfahren die Komprimierung einer oder der Gesamtheit der säulenförmigen Keramikschichten (31,..., 3i,..., 3n) umfasst.

9. Verfahren nach Anspruch 8, **dadurch gekennzeichnet, dass** das Verfahren die Komprimierung der oberen Keramikschicht (3n) oder die Komprimierung der unmittelbar unter der oberen Schicht (3n) liegenden Keramikschicht (3(n-1)) umfasst.

10. Verfahren nach einem der Ansprüche 1 bis 9, **dadurch gekennzeichnet, dass** das Wärmedämmsystem weiter eine Verbindungsschicht (2) umfasst, die zwischen dem metallischen Substrat (1) und der mindestens einen säulenförmigen Keramikschicht (3; 31,..., 3i,..., 3n) angeordnet ist.

11. Verfahren nach Anspruch 10, **dadurch gekennzeichnet, dass** es sich bei der Verbindungsschicht (2) um eine Schicht aus einem Aluminiumoxid-bildenden Material handelt, die eine Aluminiumoxidschicht auf der Oberfläche umfasst.

12. Verfahren nach Anspruch 10 oder 11, **dadurch gekennzeichnet, dass** es einen Schritt der Komprimierung der Verbindungsschicht (2) umfasst.

13. Verfahren nach Anspruch 12, **dadurch gekennzeichnet, dass** es sich bei der Komprimierung der Verbindungsschicht (2) um ein Kugelstrahlen handelt und dadurch, dass die Almenintensität des Kugelstrahlens zwischen F9N und F30A beträgt.

## Claims

1. Method for producing a thermal barrier system on a metal substrate (1) of a turbine engine part, such as a high-pressure turbine blade, the thermal barrier system comprising at least one columnar ceramic layer (3; 31, ..., 3i, ..., 3n), **characterised in that** the method comprises a step of compressing at least one of said at least one columnar ceramic layer (3; 31, ..., 3i, ..., 3n); **in that** the compression is capable of reducing the spaces between the columns of the compressed columnar ceramic layer or layers (3; 31, ..., 3i, ..., 3n).

2. Method according to claim 1, **characterised in that** the compression is a shot peening, a microbeads peening or a compression by laser shock peening.

3. Method according to claim 2, **characterised in that** the compression of at least one of said columnar ceramic layer (3; 31, ..., 3i, ..., 3n) is a shot peening and **in that** the Almen intensity of said shot peening is between F10A and F42A.

4. Method according to one of claims 1 to 3, **characterised in that** said substrate (1) is a nickel or cobalt-based superalloy substrate.

5. Method according to one of claims 1 to 4, **characterised in that** said at least one columnar ceramic layer (3; 31, ..., 3i, ..., 3n) is a layer of yttriated zirconia.

6. Method according to one of claims 1 to 5, **characterised in that** said at least one columnar ceramic layer (3; 31, ..., 3i ..., 3n) is obtained by physical vapour deposition,

7. Method according to claim 6, **characterised in that** the vapour deposition is an electron beam physical vapour deposition (EBPVD).

8. Method according to one of claims 1 to 7, **characterised in that** the thermal barrier system comprises several columnar ceramic layers (31, ..., 3i, ..., 3n), and **in that** the method comprises the compression of one or of all of the columnar ceramic layers (31, ..., 3i, ..., 3n).

9. Method according to claim 8, **characterised in that** the method comprises the compression of the upper ceramic layer (3n) or the compression of the ceramic layer (3(n-1)) located directly under said upper layer (3n).

10. Method according to one of claims 1 to 9, **characterised in that** the thermal barrier system further comprises a bonding layer (2) arranged between said metal substrate (1) and said at least one columnar ceramic layer (3; 31, ..., 3i, ..., 3n).

11. Method according to claim 10, **characterised in that** said bonding layer (2) is a layer of an aluminium-forming material comprising an alumina layer on the surface.

12. Method according to claim 10 or 11, **characterised in that** the method comprises a step of compressing said bonding layer (2).

13. Method according to claim 12, **characterised in that** the compression of said bonding layer (2) is a shot peening and **in that** the Almen intensity of said shot peening is between F9N and F30A.
